(19) Europäisches Patentamt
European Patent Office
Office européen des brevets

(11) **EP 3 609 032 B1**

(12) **EUROPÄISCHE PATENTSCHRIFT**

(45) Veröffentlichungstag und Bekanntmachung des Hinweises auf die Patenterteilung:
**10.03.2021   Patentblatt 2021/10**

(51) Int Cl.:
*H02H 7/08* *(2006.01)*        *H02H 11/00* *(2006.01)*
*G01R 31/34* *(2020.01)*

(21) Anmeldenummer: **19190277.4**

(22) Anmeldetag: **06.08.2019**

(54) **VERFAHREN ZUM ERKENNEN EINES MOTORPHASENFEHLERS AN EINER MOTORANORDNUNG UND ANTRIEBSSCHALTUNG ZUM ANTREIBEN EINES ELEKTRONISCH KOMMUTIERTEN MOTORS**

METHOD FOR DETECTING A MOTOR PHASE ERROR ON A MOTOR ARRANGEMENT AND DRIVE CIRCUIT FOR DRIVING AN ELECTRONICALLY COMMUTATED MOTOR

PROCÉDÉ DE DÉTECTION D'UNE ERREUR DE PHASE DE MOTEUR SUR UN DISPOSITIF MOTEUR ET CIRCUIT D'ENTRAÎNEMENT PERMETTANT D'ENTRAÎNER UN MOTEUR À COMMUTATION ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.08.2018   DE 102018006355**

(43) Veröffentlichungstag der Anmeldung:
**12.02.2020   Patentblatt 2020/07**

(73) Patentinhaber: **Diehl AKO Stiftung & Co. KG**
**88239 Wangen (DE)**

(72) Erfinder:
• **Weinmann, Martin**
  **88339 Bad Waldsee (DE)**
• **Schmid, Andreas**
  **88239 Wangen im Allgäu (DE)**
• **Tinius, Sebastian**
  **91207 Lauf (DE)**

(74) Vertreter: **Diehl Patentabteilung**
**c/o Diehl Stiftung & Co. KG**
**Stephanstraße 49**
**90478 Nürnberg (DE)**

(56) Entgegenhaltungen:
DE-A1-102015 105 260     DE-T2- 69 831 272
DE-T2- 69 833 097        US-A- 3 656 136
US-A- 5 243 243

**Beschreibung**

Die vorliegende Erfindung betrifft ein Verfahren zum Erkennen eines Motorphasenfehlers einer Motoranordnung, ein Verfahren zum Betreiben einer Antriebsschaltung zum Antreiben eines elektronisch kommutierten Motors mit einer solchen Motorphasenerkennung, und eine Antriebsschaltung zum Antreiben eines elektronisch kommutierten Motors.

Beim Betrieb eines elektronisch kommutierten Motors über eine Antriebsschaltung kann es auf der Seite des Motors zu verschiedenen Isolationsfehlern kommen. Zu diesen Isolationsfehlern gehören Isolationsfehler der Motorphasen, die beispielsweise durch einen Defekt des Motorkabels oder der Motorwicklung auftreten können. Außerdem kann es durch Isolationsfehler der Motorwicklungen zu einem Isolationsfehler an einem Motorsternpunkt kommen. Im Fall eines Isolationsfehlers kann ein elektrischer Strom auf Erde bzw. den Schutzleiter abfließen, wobei ein solcher Fehlerstrom eine Personengefährdung durch elektrischen Schlag und Brandgefahr darstellen kann. Ferner kann es bei Motoranordnungen zum Beispiel durch durchtrennte Motorkabel oder durchgebrannte Motorwicklungen zu Unterbrechungen von Motorphasen kommen. Es ist ein allgemeines Bestreben, Motorphasenfehler wie Isolationsfehler bzw. Fehlerströme und Motorphasenunterbrechungen zuverlässig zu erkennen, um einen weiteren Betrieb zum Beispiel einer Antriebsschaltung für einen elektronisch kommutierten Motor zu verhindern.

Die US 6 043 664 A offenbart ein Verfahren und eine Vorrichtung zur Isolationsfehlererkennung bei einem mehrphasigen Wechselstrommotor, bei denen die Spannungen aller Motorphasen gegen den Schutzleiter gemessen und aufsummiert werden, um aus einem Vergleich der über die Zeit gemittelten Spannungssumme mit einem vorgegebenen Schwellenwert das Vorhandensein eines Isolationsfehlers zu erkennen.

Die DE 10 2015 105 260 A1 offenbart eine Motorantriebsvorrichtung, die eine Funktion zum Erfassen eines Fehlers in einer Isolationswiderstandsverschlechterungserfassungseinheit eines Motors aufweist, auf welcher der Oberbegriff der Ansprüche 1 und 4 beruht.

Es ist die Aufgabe der Erfindung, ein verbessertes Verfahren zum Erkennen eines Motorphasenfehlers einer Motoranordnung, deren Motorphasen an einer Antriebsschaltung angeschlossen sind, zu schaffen.

Diese Aufgabe wird gelöst durch die Lehre der unabhängigen Ansprüche. Besonders vorteilhafte Ausgestaltungen und Weiterbildungen der Erfindung sind Gegenstand der abhängigen Ansprüche.

Bei dem erfindungsgemäßen Verfahren zum Erkennen eines Motorphasenfehlers einer Motoranordnung, deren Motorphasen an einer Antriebsschaltung mit einem Gleichspannungszwischenkreis und einem Wechselrichter angeschlossen sind, wird eine Motorphasenspannung an mindestens einer der Motorphasen gegen ein Bezugspotenzial erfasst, während der Wechselrichter ausgeschaltet ist, und wird anhand eines Spannungsverlaufs der erfassten Motorphasenspannung festgestellt, ob ein Motorphasenfehler an einer der Motorphasen der Motoranordnung vorhanden ist.

Gemäß der Erfindung wird vorgeschlagen, das Prüfen auf das Vorhandensein eines Motorphasenfehlers einer Motoranordnung wie eines Isolationsfehlers an einer Motorphase oder eine Unterbrechung einer Motorphase der Motoranordnung während eines ausgeschalteten Wechselrichters durchzuführen und dabei nur eine Motorphase einer oder mehrerer Motorphasen zu erfassen, um aus deren Spannungsverlauf das Vorhandensein eines Motorphasenfehlers erkennen zu können. Die Fehlerprüfung kann auf diese Weise mit einem einfachen Schaltungsaufbau und einer einfachen Messsignalauswertung durchgeführt werden.

Die Motoranordnung umfasst insbesondere einen Motor und ein Motorkabel zum Anschließen des Motors an eine Antriebsschaltung. Zu den erkennbaren Isolationsfehlern an den Motorphasen zählen insbesondere Isolationsfehlern an den Motorphasen des Motorkabels, an den Motorwicklungen und an einem Sternpunkt der Motorwicklungen. Zu den erkennbaren Unterbrechungen von Motorphasen zählen insbesondere durchtrennte Motorkabel und durchgebrannte Motorwicklungen. Derartige Isolationsfehler und derartige Unterbrechungen von Motorphasen werden in Zusammenhang mit der vorliegenden Erfindung gemeinsam als Motorphasenfehler bezeichnet.

Unter einem ausgeschalteten Wechselrichter ist in diesem Zusammenhang ein Wechselrichter zu verstehen, der den angeschlossenen Motor nicht aktiv bestromt. Dies kann insbesondere dadurch erreicht werden, dass alle Leistungsschalter des Wechselrichters ausgeschaltet bzw. offen sind. Die Fehlerprüfung kann vor dem Starten des Motors durch Einschalten des Wechselrichters oder in einer Betriebspause des Motors durch Ausschalten des Wechselrichters erfolgen. Vorzugsweise wird die Fehlerprüfung durchgeführt, wenn der Wechselrichter ausgeschaltet ist und sich zudem der Motor im Stillstand befindet, sodass auch der Rotor des Motors nicht dreht und dadurch Spannungen induzieren könnte, welche die Erkennung eines Motorphasenfehlers beeinflussen könnten.

Die Erfindung ist auf keine spezielle Motorart beschränkt. Bei dem Motor der Motoranordnung handelt es sich insbesondere um einen elektronisch kommutierten Motor wie beispielsweise einen Synchronmotor oder Asynchronmotor, einen Wechselstrommotor, einen Drehstrommotor oder dergleichen.

Der Gleichspannungszwischenkreis der Antriebsschaltung weist vorzugsweise einen Zwischenkreiskondensator auf. Der Wechselrichter der Antriebsschaltung weist vorzugsweise eine Wechselrichter-Brückenschaltung, bevorzugt mit mehreren Leistungsschaltern (z.B. MOSFETs oder IGBTs mit antiparallel geschalteten Dioden) auf. Der Wechselrichter ist entsprechend dem angeschlossenen Motor vorzugsweise mehrphasig ausgestaltet.

Der Gleichspannungszwischenkreis der Antriebsschaltung ist vorzugsweise über einen Gleichrichter mit einem Wechselstromanschluss verbunden, an welchen das jeweilige Versorgungsnetz angeschlossen werden kann. Die Antriebsschaltung kann beispielsweise an einphasige Stromnetze, dreiphasige Stromnetze, Einphasen-Dreileiternetze (USA) oder dergleichen angeschlossen werden. Dementsprechend ist der Gleichrichter der Antriebsschaltung vorzugsweise als Brückengleichrichter oder Mittelpunktgleichrichter mit mehreren Gleichrichterdioden ausgebildet.

In einer ersten Alternative des Verfahrens der Erfindung wird mindestens eine Motorphase über erste Widerstände mit einem ersten Bezugspotenzial und über weitere Widerstände mit einem zweiten Bezugspotenzial verbunden, um dann mittels eines Spannungsteilers eine entsprechend runtergeteilte Motorphasenspannung der ausgewählten Motorphase zu erfassen. Das zweite Bezugspotenzial ist ein von dem ersten Bezugspotenzial verschiedenes Bezugspotenzial. Bei dem ersten Bezugspotenzial handelt es sich beispielsweise um den Minuspol des Gleichspannungszwischenkreises oder um Masse; bei dem zweiten Bezugspotenzial handelt es sich beispielsweise um den Pluspol des Gleichspanungszwischenkreises. Die Summe der Widerstandswerte ersten Widerstände ist vorzugsweise hochohmig und beträgt zum Beispiel etwa ein Megaohm. Wahlweise kann auch die Summe der Widerstandswerte der weiteren Widerstände vorzugsweise hochohmig sein. Die Summe der Widerstandswerte der ersten Widerstände und die Summe der Widerstandswerte der weiteren Widerstände können im Fall des Anschlusses der Antriebsschaltung an ein- oder mehrphasige Stromnetze vorzugsweise gleich gewählt sein, im Fall des Anschlusses der Antriebsschaltung an ein Einphasen-Dreileiternetz (USA) sollten sie hingegen unterschiedlich groß gewählt sein. Mit dieser Ausführungsvariante kann auf einfache Weise eine Fehlerprüfung durchgeführt werden, ob ein Isolationsfehler an einer der Motorphasen vorhanden ist.

In einer zweiten Alternative des Verfahrens der Erfindung wird eine erste Motorphase über erste Widerstände mit einem ersten Bezugspotenzial verbunden und werden die anderen Motorphasen jeweils über weitere Widerstände mit einem zweiten Bezugspotenzial verbunden, um dann mittels eines Spannungsteilers eine entsprechend runtergeteilte Motorphasenspannung der ersten Motorphase zu erfassen. Das zweite Bezugspotenzial ist ein von dem ersten Bezugspotenzial verschiedenes Bezugspotenzial. Bei dem ersten Bezugspotenzial handelt es sich beispielsweise um den Minuspol des Gleichspannungszwischenkreises oder um Masse; bei dem zweiten Bezugspotenzial handelt es sich beispielsweise um den Pluspol des Gleichspanungszwischenkreises. Die Summe der Widerstandswerte der ersten Widerstände ist vorzugsweise hochohmig und beträgt zum Beispiel etwa ein Megaohm. Die Summe der Widerstandswerte der weiteren Widerstände ist ebenfalls jeweils vorzugsweise hochohmig. Im Fall des Anschlusses der Antriebsschaltung an ein- oder mehrphasige Stromnetze und von insgesamt drei Motorphasen ist die Summe der Widerstandswerte der weiteren Widerstände jeweils vorzugsweise doppelt so groß wie die Summe der Widerstandswerte der ersten Widerstände. Mit dieser Ausführungsvariante kann auf einfache Weise eine Fehlerprüfung durchgeführt werden, mit der das Vorhandensein eines Isolationsfehlers an einer der Motorphasen oder einer Unterbrechung einer Motorphase erkannt werden kann.

Gemäß der Erfindung wird die runtergeteilte Motorphasenspannung mittels eines Spannungsteilers erfasst. Die mittels eines Spannungsteilers gemessene Messspannung kann in vorteilhafter Weise von einem Analog-Digital-Wandler zum Beispiel eines Mikrocontrollers ausgewertet werden. Der Spannungsteiler wird vorzugsweise durch zwei Widerstände der ersten Widerstände zwischen der einen bzw. ersten Motorphase und dem ersten Bezugspotenzial gebildet.

Gemäß der Erfindung können anhand der erfassten Motorphasenspannung ein Fehlerstromwert eines Isolationsfehlers während der Fehlerprüfung und/oder ein Widerstandswert des Isolationsfehlers und/oder ein maximal möglicher Fehlerstromwert des Isolationsfehlers im Betrieb mit eingeschaltetem Wechselrichter quantitativ berechnet werden.

Das erfindungsgemäße verfahren ist außerdem dadurch gekennzeichnet, dass der Fehlerstromwert des Isolationsfehlers während der Fehlerprüfung und/oder der Widerstandswert des Isolationsfehlers und/oder der maximal mögliche Fehlerstromwert des Isolationsfehlers allein anhand der Widerstandswerte der ersten Widerstände und der weiteren Widerstände, einer mittels des Spannungsteilers erfassten Messspannung der runtergeteilten Motorphasenspannung, einer Netzspannung des Versorgungsnetzes und einer Zwischenkreisspannung über dem Gleichspannungszwischenkreis berechnet werden. Die konkrete Berechnungsformel hängt dabei von der Art des Versorgungsnetzes, an das die Antriebsschaltung angeschlossen ist, und des dementsprechenden Gleichrichters ab. Außerdem hängt die konkrete Berechnungsformel davon ab, ob die Erfassung und Auswertung der Motorphasenspannung in einer positiven Halbwelle oder einer negativen Halbwelle der Netzspannung erfolgt.

Der maximal mögliche Fehlerstrom ist in diesem Zusammenhang der größtmögliche Fehlerstrom, der im normalen Motorbetrieb mit eingeschaltetem Wechselrichter der Antriebsschaltung fließt. Bei der erfindungsgemäßen Fehlerprüfung kann zwar nicht ermittelt werden, ob der festgestellte Isolationsfehler an einer der Motorphasen oder am Motorsternpunkt vorliegt. Dennoch kann ein maximaler Fehlerstrom definiert werden als der Quotient aus der Zwischenkreisspannung und dem ermittelten Widerstandswert des Isolationsfehlers. D.h. der maximale Fehlerstrom tritt immer dann auf, wenn über dem Isolationsfehler die Zwischenkreisspannung anliegt. Das ist entweder dann der Fall, wenn die vom Isolationsfehler betroffene Motorphase auf high geschaltet wird oder wenn im Fall eines Isolationsfehlers vom Sternpunkt gegen Schutzerde die Antriebsschaltung den Motor in den Nullvektor (alle Motorphasen gleichzeitig auf high) schaltet und der Sternpunkt deshalb die Zwischenkreisspannung annimmt.

Gegenstand der Erfindung ist auch ein Verfahren zum Betreiben einer Antriebsschaltung mit einem Gleichspannungszwischenkreis und einem Wechselrichter zum Antreiben eines elektronisch kommutierten Motors, wobei die Motorphasen einer den Motor enthaltenden Motoranordnung an dem Wechselrichter der Antriebsschaltung angeschlossen sind. Das Vorhandensein eines Motorphasenfehlers der Motoranordnung wird nach dem oben beschriebenen Verfahren der Erfindung zum Erkennen eines Motorphasenfehlers geprüft. Falls mit diesem Verfahren ein Motorphasenfehler festgestellt worden ist, wird dann ein Einschalten des Wechselrichters und/oder eines Leistungsfaktorkorrekturfilters (falls vorhanden) der Antriebsschaltung nach dem Erfassen der runtergeteilten Motorphasenspannung verhindert.

Gegenstand der Erfindung ist auch ein Verfahren zum Betreiben einer Antriebsschaltung mit einem Gleichspannungszwischenkreis, einem Leistungsfaktorkorrekturfilter und einem Wechselrichter zum Antreiben eines elektronisch kommutierten Motors, wobei die Motorphasen einer den Motor enthaltenden Motoranordnung an dem Wechselrichter der Antriebsschaltung angeschlossen sind. Das Vorhandensein eines Motorphasenfehlers der Motoranordnung wird nach dem oben beschriebenen Verfahren der Erfindung zum Erkennen eines Motorphasenfehlers geprüft. Falls mit diesem Verfahren ein maximal möglicher Fehlerstromwert für einen Isolationsfehler an einer Motorphase unterhalb eines vorgegebenen Grenzwerts festgestellt worden ist, wird dann der Leistungsfaktorkorrekturfilter der Antriebsschaltung beim Antreiben des Motors nach dem Erfassen der runtergeteilten Motorphasenspannung abgeschaltet, um den Motor mit geringer Leistung anzutreiben. Vorzugsweise kann in diesem Fall zudem ein Fehlersignal für den Benutzer bzw. den Kundendienst generiert werden. Der vorgegebene Grenzwert für den Fehlerstrom beträgt vorzugsweise 6 mA (z.B. bei Verwendung eines Fehlerstromschutzschalters des Typs A) oder 10 mA (z.B. bei Verwendung eines Fehlerstromschutzschalters des Typs F).

Gegenstand der Erfindung ist ferner eine Antriebsschaltung zum Antreiben eines elektronisch kommutierten Motors, die einen Gleichspannungszwischenkreis und einen mit dem Gleichspannungszwischenkreis verbundenen Wechselrichter, an den die Motorphasen einer den Motor enthaltenden Motoranordnung anschließbar sind, eine Detektionsschaltung zum Erfassen einer Motorphasenspannung an mindestens einer der Motorphasen gegen ein Bezugspotenzial und eine Steuereinrichtung, die ausgestaltet ist, um die Detektionsschaltung zum Erfassen der Motorphasenspannung zu betreiben, während der Wechselrichter ausgeschaltet ist, und um anhand eines Spannungsverlaufs der erfassten Motorphasenspannung festzustellen, ob ein Motorphasenfehler an einer der Motorphasen der Motoranordnung vorhanden ist, aufweist. Die Detektionsschaltung weist erste Widerstände, über die mindestens eine Motorphase mit einem ersten Bezugspotenzial verbunden ist, und weitere Widerstände, über die die mindestens eine Motorphase mit einem zweiten Bezugspotenzial verbunden ist, oder erste Widerstände, über die eine erste Motorphase der Motorphasen mit einem ersten Bezugspotenzial verbunden ist, und weitere Widerstände, über die jeweils eine andere Motorphase der Motorphasen mit einem zweiten Bezugspotenzial verbunden ist, sowie einen Spannungsteiler zum Erfassen einer runtergeteilten Motorphasenspannung der einen Motorphase oder einer runtergeteilten Motorphasenspannung der ersten Motorphase auf. Außerdem ist die Steuereinrichtung ferner ausgestaltet, um anhand der erfassten Motorphasenspannung einen Fehlerstromwert eines Isolationsfehlers während der Fehlerprüfung und/oder einen Widerstandswert des Isolationsfehlers und/oder einen maximal möglichen Fehlerstromwert des Isolationsfehlers im Betrieb mit eingeschaltetem Wechselrichter allein anhand der Widerstandswerte der ersten Widerstände und der weiteren Widerstände, einer mittels des Spannungsteilers erfassten Messspannung der runtergeteilten Motorphasenspannung, einer Netzspannung eines Versorgungsnetzes und einer Zwischenkreisspannung über dem Gleichspannungszwischenkreis quantitativ zu berechnen.

Mit dieser Antriebsschaltung können die gleichen Vorteile wie mit dem oben beschreiben Verfahren zum Erkennen eines Motorphasenfehlers erzielt werden. Bezüglich der vorteilhaften Ausgestaltungen und Begriffserläuterungen wird ebenfalls ergänzend auf die obigen Ausführungen in Zusammenhang mit dem Verfahren zum Erkennen eines Motorphasenfehlers verwiesen.

In einer Ausgestaltung der Erfindung ist die Steuereinrichtung zudem ausgestaltet, um ein Einschalten des Wechselrichters und/oder eines Leistungsfaktorkorrekturfilters (falls vorhanden) nach dem Erfassen der Motorphasenspannung zu verhindern, falls ein Motorphasenfehler festgestellt worden ist. Falls die Antriebsschaltung ferner einen Leistungsfaktorkorrekturfilter aufweist, kann die Steuereinrichtung vorzugsweise ferner ausgestaltet sein, um den Leistungsfaktorkorrekturfilter beim Antreiben des Motors nach dem Erfassen der Motorphasenspannung abzuschalten, falls der maximal mögliche Fehlerstromwert des Isolationsfehlers an einer Motorphase unterhalb eines vorgegebenen Grenzwerts festgestellt worden ist.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, zum Teil schematisch:

Fig. 1    ein Schaltbild einer Antriebsschaltung mit angeschlossenem Motor gemäß einem ersten Ausführungsbeispiel der Erfindung;

Fig. 2    Diagramme der Netzspannung, des Fehlerstroms und der Motorphasenspannungen während der Fehlerprüfung für die Antriebsschaltung von Fig. 1 im fehlerfreien Fall ohne Isolationsfehler;

Fig. 3    Diagramme der Netzspannung, des Fehlerstroms und der Motorphasenspannungen während der Fehlerprüfung für die Antriebsschaltung von Fig. 1 im Fall eines Isolationsfehlers an einer der Motorphasen;

Fig. 4    ein Schaltbild einer Antriebsschaltung mit angeschlossenem Motor gemäß einem zweiten Ausführungsbeispiel der Erfindung;

Fig. 5    Diagramme der Netzspannung, des Fehlerstroms und der Motorphasenspannungen während der Fehlerprüfung für die Antriebsschaltung von Fig. 4 im fehlerfreien Fall ohne Isolationsfehler;

Fig. 6    Diagramme der Netzspannung, des Fehlerstroms und der Motorphasenspannungen während der Fehlerprüfung für die Antriebsschaltung von Fig. 4 im Fall eines Isolationsfehlers an einer der Motorphasen;

Fig. 7    ein Schaltbild einer Antriebsschaltung mit angeschlossenem Motor gemäß einem dritten Ausführungsbeispiel der Erfindung;

Fig. 8    Diagramme der Netzspannung, des Fehlerstroms und der Motorphasenspannungen während der Fehlerprüfung für die Antriebsschaltung von Fig. 7 im fehlerfreien Fall ohne Isolationsfehler;

Fig. 9    Diagramme der Netzspannung, des Fehlerstroms und der Motorphasenspannungen während der Fehlerprüfung für die Antriebsschaltung von Fig. 7 im Fall eines Isolationsfehlers an einer der Motorphasen;

Fig. 10    ein Schaltbild einer Antriebsschaltung mit angeschlossenem Motor gemäß einem vierten Ausführungsbeispiel der Erfindung;

Fig. 11    Diagramme der Netzspannung, des Fehlerstroms und der Motorphasenspannungen während der Fehlerprüfung für die Antriebsschaltung von Fig. 10 im fehlerfreien Fall ohne Isolationsfehler;

Fig. 12    Diagramme der Netzspannung, des Fehlerstroms und der Motorphasenspannungen während der Fehlerprüfung für die Antriebsschaltung von Fig. 10 im Fall eines Isolationsfehlers an einer der Motorphasen; und

Fig. 13    ein Schaltbild einer Ausführungsvariante der Detektionsschaltung gemäß der vorliegenden Erfindung.

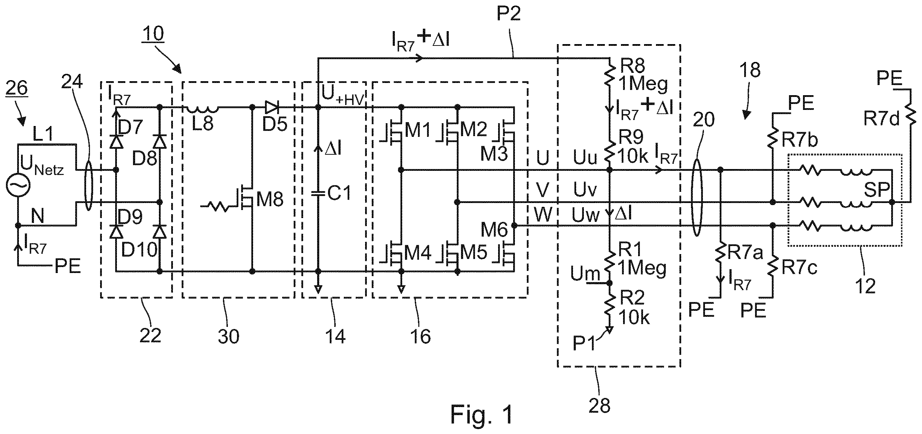

Bezug nehmend auf Fig. 1 bis 3 werden Aufbau und Funktionsweise einer Antriebsschaltung für einen elektronisch kommutierten Motor gemäß einem ersten Ausführungsbeispiel näher erläutert.

Die Antriebsschaltung 10 dient dem Antreiben eines elektronisch kommutierten Motors 12. Im Ausführungsbeispiel von Fig. 1 handelt es sich um einen dreiphasigen bürstenlosen Drehstrommotor 12 mit drei Motorphasen U, V, W, die an einem Sternpunkt SP miteinander verbunden sind. Der Motor 12 wird aus einem Gleichspannungszwischenkreis 14 über einen Wechselrichter 16 gespeist. Der Gleichspannungszwischenkreis 14 weist einen Zwischenkreiskondensator C1 auf, und der Wechselrichter 16 weist eine in diesem Ausführungsbeispiel dreiphasige Wechselrichter-Brückenschaltung mit insgesamt sechs Leistungsschaltern M1 bis M6 (z.B. MOSFETs oder IGBTs mit antiparallel geschalteten Dioden) in seinen Halbbrücken auf. Die drei Motorwicklungen des Motors 12 sind über ein Motorkabel 18 an einen Motorphasenanschluss 20 angeschlossen, der mit den drei Mittelabgriffen der Halbbrücken des Wechselrichters 16 verbunden ist. Der Motor 12 und das Motorkabel 18 haben jeweils drei Motorphasen U, V, W und sind Bestandteile der Motoranordnung.

Eingangsseitig ist der Gleichspannungszwischenkreis 14 über einen Gleichrichter 22 mit einem Wechselstromanschluss 24 verbunden. Über den Wechselstromanschluss 24 ist die Antriebsschaltung 10 mit einem Versorgungsnetz 26 verbunden. Im Ausführungsbeispiel von Fig. 1 ist das Versorgungsnetz 26 ein einphasiges Stromnetz, ist die Antriebsschaltung 10 mit dem Phasenleiter L1 und dem Neutralleiter N des einphasigen Stromnetzes verbunden, und hat das Versorgungsnetz 26 zudem eine Schutzerdung PE. Der Gleichrichter 22 weist in diesem Ausführungsbeispiel eine Gleichrichter-Brückenschaltung mit insgesamt vier Gleichrichterdioden D7 bis D10 auf.

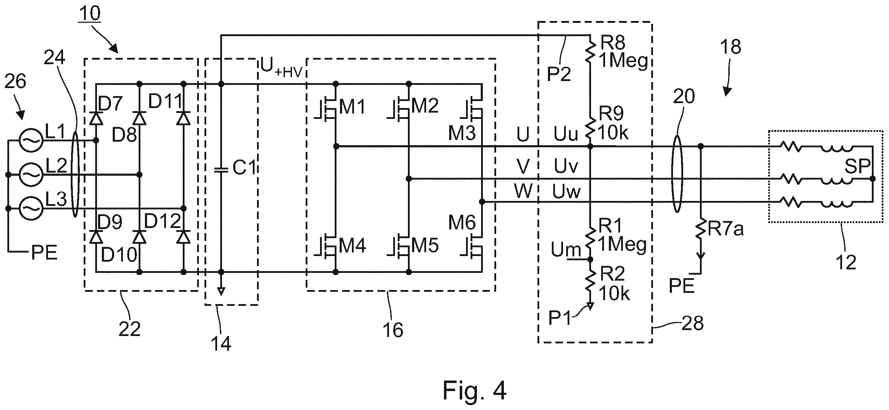

Optional kann zwischen den Gleichrichter 22 und den Gleichspannungszwischenkreis 14 zudem ein Leistungsfaktorkorrekturfilter (PFC-Filter) 30 geschaltet sein. Der PFC-Filter 30 ist in diesem Beispiel in einer Hochsetzsteller-Topologie ausgestaltet und enthält insbesondere eine Induktivität L8, einen Schalter M8 und eine Gleichrichterdiode D5. Der PFC-Filter 30 kann optional auch in den anderen Ausführungsbeispielen vorhanden sein, auch wenn er in Fig. 4, 7 und 10 nicht eingezeichnet ist.

Die Antriebsschaltung 10 hat ferner eine Steuereinrichtung (nicht dargestellt) zum Beispiel in Form eines Mikrocontrollers, die die Leistungsschalter M1 bis M6 des Wechselrichters 16 ansteuert.

Bei einer solchen Antriebsschaltung 10 gibt es verschiedene Arten von Motorphasenfehlern, die auf der Seite des angeschlossenen Motors 12 auftreten können. Es kann zu Isolationsfehlern der Motorphasen im Motorkabel 18 sowie zu Isolationsfehlern des Sternpunkts SP der Motorwicklungen des Motors 12 kommen. Die verschiedenen Arten von Isolationsfehlern sind in Fig. 1 als Isolationsfehler mit den Widerständen R7a, R7b, R7c für die Motorphasen U, V, W des Motorkabels 18 bzw. dem Widerstand R7d für den Sternpunkt SP der Motorwicklungen des Motors 12 dargestellt.

Zum Erkennen all dieser Isolationsfehler R7a, R7b, R7c, R7d weist die Antriebsschaltung 10 eine Detektionsschaltung 28 auf.

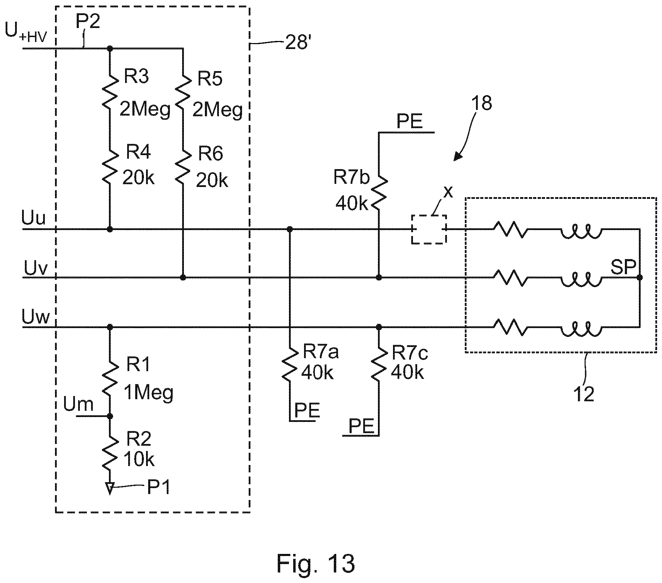

Außerdem kann es aufgrund eines durchtrennten Motorkabels 18 oder einer durchgebrannten Motorwicklung des Motors 12 zu Unterbrechungen der Motorphasen U, V, W kommen. In Fig. 1 ist beispielhaft eine Unterbrechung X der Motorphase U im Motorkabel 18 angedeutet. Zum Erkennen solcher Unterbrechungen X von Motorphasen U, V, W kann die Antriebsschaltung 10 alternativ eine Detektionsschaltung 28' aufweisen, die beispielhaft in Fig. 13 veranschaulicht ist und später in mehr Einzelheiten beschrieben wird.

Die Detektionsschaltung 28 von Fig. 1 erfasst bei ausgeschaltetem Wechselrichter 16 und vorzugsweise auch bei ausgeschaltetem PFC-Filter 30 (falls vorhanden) die Motorphasenspannung Uu der Motorphase U (allgemein mindestens einer der Motorphasen U, V, W)-. Zu diesem Zweck ist die Motorphase U über erste Widerstände R1, R2 hochohmig mit dem Minuspol des Gleichspannungszwischenkreises 14 bzw. Masse als erstem Bezugspotenzial P1 verbunden und über weitere Widerstände R8, R9 hochohmig mit dem Pluspol des Gleichspannungszwischenkreises 14 als zweitem Bezugspotenzial P2 verbunden. Die ersten Widerstände R1, R2 dienen zudem als Spannungsteiler zum Erfassen der runtergeteilten Motorphasenspannung Uu als Messspannung Um, die von einem Analog-Digital-Wandler der Steuereinrichtung ausgewertet werden kann. Bei dem erfindungsgemäßen Motorphasenfehlererkennungsverfahren genügt das Erfassen einer der Motorphasenspannungen, wahlweise können aber auch Motorphasenspannungen mehrerer Motorphasen erfasst und ausgewertet werden.

Das Ausschalten des Wechselrichters 16 wird durch Ausschalten / Öffnen aller Leistungsschalter M1..M6 des Wechselrichters 16 erreicht, sodass der an den Motorphasenanschluss 20 angeschlossene Motor 12 von der Antriebsschaltung 10 nicht aktiv bestromt wird. Vorzugsweise wird die Fehlerprüfung durch die Detektionsschaltung 28 nicht nur bei ausgeschaltetem Wechselrichter 16, sondern auch bei Motorstillstand ausgeführt, sodass keine Spannungen durch einen noch drehenden Rotor des Motors 12 induziert werden können.

Im Ausführungsbeispiel von Fig. 1 ist die Summe der Widerstandswerte der ersten Widerstände R1, R2 gleich der Summe der Widerstandswerte der weiteren Widerstände R8, R9 gewählt, wobei diese Summen der Widerstandswerte jeweils etwa 1 Megaohm betragen. Hierdurch nimmt die Motorphasenspannung Uu im fehlerfreien Zustand den halben Wert der Zwischenkreisspannung $U_{+HV}$ über dem Gleichspannungszwischenkreis 14 an. Anstelle der zwei weiteren Widerstände R8, R9 kann auch nur ein einzelner Widerstand R8 vorgesehen sein.

Anhand der Fig. 1 bis 3 wird nun beschrieben, wie das Vorhandensein eines Isolationsfehlers R7a, R7b, R7c, R7d mit Hilfe dieser Detektionsschaltung 28 erkannt werden kann. In Fig. 1 sind hierzu beispielhaft die Strompfeile des Fehlerstroms $I_{R7}$ sowie des Kondensatorstroms $\Delta I$ aus dem Gleichspannungszwischenkreis 14 in der positiven Halbwelle der Netzspannung $U_{Netz}$ des Versorgungsnetzes 26 bei ausgeschaltetem Wechselrichter 16 mit ausgeschalteten / offenen Leistungsschaltern M1..6 eingezeichnet.

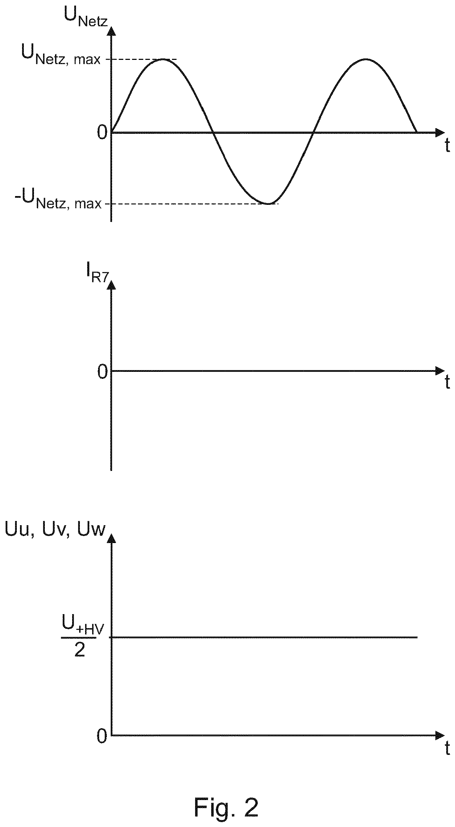

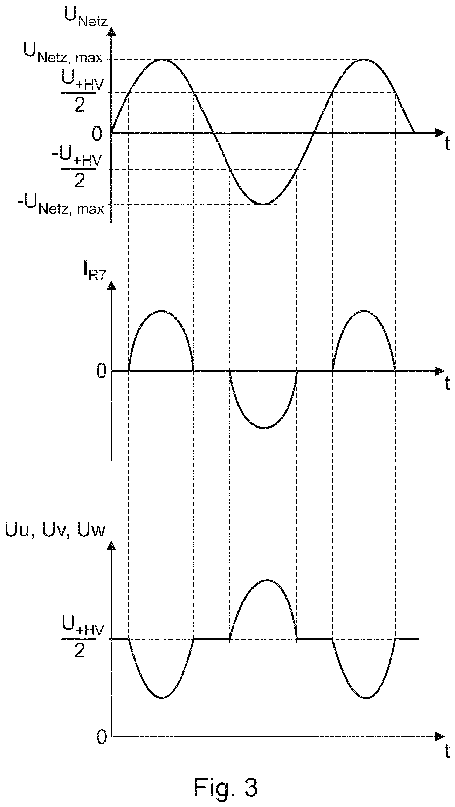

Die Diagramme von Fig. 2 zeigen die zeitlichen Verläufe der Netzspannung $U_{Netz}$, des Fehlerstroms $I_{R7}$ und der Motorphasenspannungen Uu, Uv, Uw im fehlerfreien Fall ohne einen Isolationsfehler, und die Diagramme von Fig. 3 zeigen die zeitlichen Verläufe der Netzspannung $U_{Netz}$, des Fehlerstroms $I_{R7}$ und der Motorphasenspannungen Uu, Uv, Uw im Fall eines Isolationsfehlers, jeweils während der Fehlerprüfung. Die Kurvenverläufe von Fig. 2 und 3 zeigen den Fall einer Fehlerprüfung bei ausgeschaltetem PFC-Filter 30; die Fehlerprüfung kann aber in analoger Weise auch bei eingeschaltetem PFC-Filter 30 durchgeführt werden.

Da im fehlerfreien Fall der Isolationsfehlerwiderstand unendlich groß ist, nimmt die Motorphasenspannung Uu (für den Fall R1+R2 = R8+R9) die halbe Zwischenkreisspannung $U_{+HV}/2$ an. Wie ein Vergleich der Diagramme der Fig. 2 und 3 zeigt, kann aus einem Spannungsverlauf der Motorphasenspannung Uu auf einfache Weise erkannt werden, ob ein Isolationsfehler auf der Seite der Motoranordnung 12, 18 vorliegt oder nicht.

Der Fehlerstrom $I_{R7}$ fließt erst dann, wenn in der positiven Halbwelle der Netzspannung $U_{Netz}$ die Diode D7 des Gleichrichters 22 bzw. in der negativen Halbwelle der Netzspannung $U_{Netz}$ die Diode D9 des Gleichrichters 22 leitend ist. Dieser Zustand tritt bei ausgeschaltetem Wechselrichter 16 erst dann ein, wenn die Netzspannung $U_{Netz}$ den halben Wert der Zwischenkreisspannung $U+_{HV}/2$ überschreitet. Wie in Fig. 3 dargestellt, fließt aus diesem Grund erst dann ein Fehlerstrom $I_{R7}$, wenn die Netzspannung $U_{Netz}$ betragsmäßig größer als die halbe Zwischenkreisspannung $U+_{HV}/2$ ist.

Die Motorphasenspannung Uu kann durch eine einfache Spannungsteilerformel als Funktion der gemessenen runtergerteilten Spannung Um ausgedrückt werden:

$$Uu = \frac{R1 + R2}{R2} * Um$$

In der positiven Halbwelle der Netzspannung $U_{Netz}$ kann der Isolationsfehlerwiderstand R7 durch folgenden Ausdruck berechnet werden:

$$R7 = \frac{(R8 + R9) * \left(U_{Netz} - U_{+HV} + \frac{Um * (R1 + R2)}{R2}\right)}{2 * Uu - U_{+HV}}$$

und in der negativen Halbwelle der Netzspannung $U_{Netz}$ kann der Isolationsfehlerwiderstand R7 durch folgenden Ausdruck berechnet werden:

$$R7 = -\frac{U_{Netz} - \frac{R1 + R2}{R2} * Um}{\frac{Um}{R2} - \left(U_{+HV} - \frac{R1 + R2}{R2} * Um\right)/(R8 + R9)}$$

In der positiven Halbwelle der Netzspannung $U_{Netz}$ kann der Fehlerstrom $I_{R7}$ während der Fehlerprüfung durch folgenden Ausdruck berechnet werden:

$$I_{R7} = -\frac{U_{+HV} - \frac{R8 + R9 + R1 + R2}{R2} * Um}{R8 + R9}$$

und in der negativen Halbwelle der Netzspannung $U_{Netz}$ kann der Fehlerstrom $I_{R7}$ während der Fehlerprüfung durch folgenden Ausdruck berechnet werden:

$$I_{R7} = \frac{Um}{R2} - \frac{U_{+HV} - \frac{R1 + R2}{R2} * Um}{R8 + R9}$$

Der maximal mögliche Fehlerstrom $I_{R7,max}$ im Betrieb mit eingeschaltetem Wechselrichter 16 kann, ausgehend von dem Quotienten aus der Zwischenkreisspannung und dem ermittelten Widerstandswert R7 des Isolationsfehlers, während der positiven Halbwelle der Netzspannung $U_{Netz}$ durch folgenden Ausdruck ermittelt werden:

$$I_{R7,max} = \frac{U_{+HV}}{R7} = -\frac{U_{+HV} * (2 * Uu - U_{+HV})}{(R8 + R9) * \left(U_{Netz} - U_{+HV} + \frac{Um * (R1 + R2)}{R2}\right)}$$

und in der negativen Halbwelle der Netzspannung $U_{Netz}$ kann der maximal mögliche Fehlerstrom $I_{R7,max}$ durch folgenden Ausdruck berechnet werden:

$$I_{R7,max} = \frac{U_{+HV}}{R7} = -\frac{U_{+HV} * \left(\frac{Um}{R2} - \left(U_{+HV} - \frac{R1 + R2}{R2} * Um\right)/(R8 + R9)\right)}{U_{Netz} - \frac{R1 + R2}{R2} * Um}$$

D.h. die Isolationsfehlerwiderstände R7, die Fehlerstromwerte $I_{R7}$ des Isolationsfehlers und die maximal möglichen Fehlerstromwerte $I_{R7,max}$ im Betrieb mit eingeschaltetem Wechselrichter 16 können allein anhand der Widerstandswerte der ersten und der weiteren Widerstände R1, R2, R8, R9 der Detektionsschaltung 28, der mittels des Spannungsteilers R1, R2 der Detektionsschaltung 28 erfassten Messspannung Um der runtergeteilten Motorphasenspannung Uu, der Zwischenkreisspannung $U_{+HV}$ über dem Gleichspannungszwischenkreis 14 und der Netzspannung $U_{Netz}$ berechnet werden.

Neben der qualitativen Erkennung eines Isolationsfehlers kann mit Hilfe der beiden letzten Ausdrücke auch eine quantitative Erkennung eines Isolationsfehlers erfolgen. Die so berechneten maximal möglichen Fehlerstromwerte $I_{R7,max}$ können beispielsweise mit vorgegebenen Grenzwerten verglichen werden. Zum Beispiel wird bei einem 6 mA übersteigenden Fehlerstromwert $I_{R7}$ auf einen Isolationsfehler erkannt. Falls hingegen nur ein geringer maximal möglicher Fehlerstromwert $I_{R7,max}$ unterhalb eines vorgegebenen Grenzwerts von beispielsweise 6 mA oder 10 mA festgestellt wird, so kann der Motor 12 anschließend mit gegebenenfalls geringer Leistung mit abgeschaltetem PFC-Filter 30 betrieben werden und zudem ein Fehlersignal an den Benutzer oder Kundendienst gesendet werden.

Die Antriebsschaltung 10 mit der erfindungsgemäßen Detektionsschaltung 28 zum Erkennen eines Isolationsfehlers auf der Seite der Motoranordnung 12, 18 kann auch in Kombination mit anderen Versorgungsnetzen 26 und entsprechend angepassten Gleichrichtern 22 eingesetzt werden.

Bezug nehmend auf Fig. 4 bis 6 werden Aufbau und Funktionsweise einer Antriebsschaltung für einen elektronisch kommutierten Motor gemäß einem zweiten Ausführungsbeispiel näher erläutert. Dabei sind gleiche bzw. entsprechende Komponenten und Parameter mit den gleichen Bezugszeichen wie im ersten Ausführungsbeispiel versehen.

Im Ausführungsbeispiel von Fig. 4 ist das Versorgungsnetz 26 ein dreiphasiges Stromnetz, ist die Antriebsschaltung 10 mit den Phasenleitern L1, L2, L3 des Stromnetzes verbunden, und hat das Versorgungsnetz 26 zudem eine Schutzerdung PE. Der Gleichrichter 22 weist in diesem Ausführungsbeispiel eine Gleichrichter-Brückenschaltung mit insgesamt sechs Gleichrichterdioden D7 bis D12 auf. Im Übrigen entspricht die Antriebsschaltung 10 jener des ersten Ausführungsbeispiels von Fig. 1.

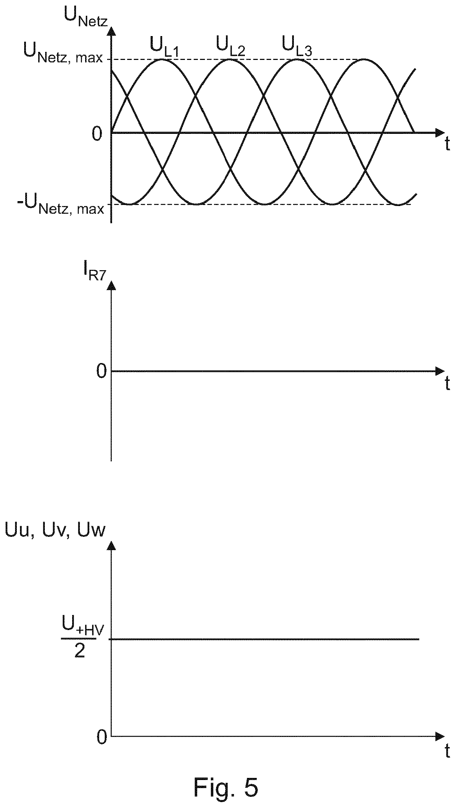

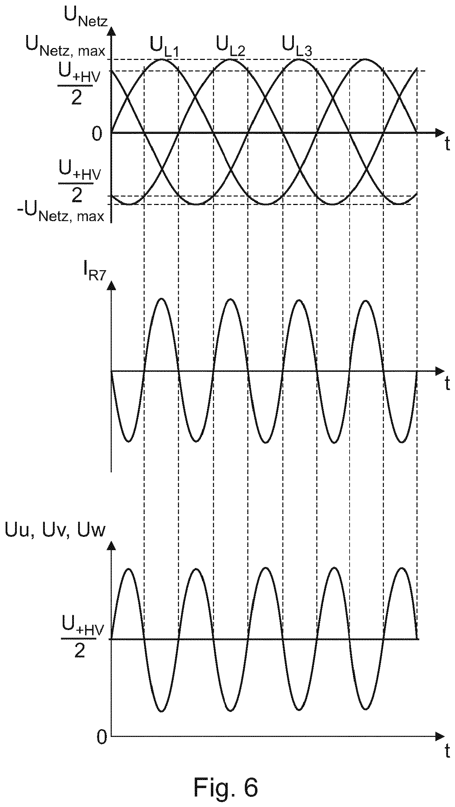

Die Diagramme von Fig. 5 zeigen die zeitlichen Verläufe der Netzspannung $U_{Netz}$, des Fehlerstroms $I_{R7}$ und der Motorphasenspannungen Uu, Uv, Uw im fehlerfreien Fall ohne einen Isolationsfehler, und die Diagramme von Fig. 6 zeigen die zeitlichen Verläufe der Netzspannung $U_{Netz}$, des Fehlerstroms $I_{R7}$ und der Motorphasenspannungen Uu, Uv, Uw im Fall eines Isolationsfehlers, jeweils während der Fehlerprüfung. Die Kurvenverläufe von Fig. 5 und 6 zeigen den Fall einer Fehlerprüfung für eine Antriebsschaltung 10 ohne PFC-Filter 30 bzw. bei ausgeschaltetem PFC-Filter 30; die Fehlerprüfung kann aber in analoger Weise auch bei eingeschaltetem PFC-Filter 30 durchgeführt werden.

Da im fehlerfreien Fall der Isolationsfehlerwiderstand unendlich groß ist, nimmt die Motorphasenspannung Uu (für den Fall R1+R2 = R8+R9) die halbe Zwischenkreisspannung U+$_{HV}$/2 an. Wie ein Vergleich der Diagramme der Fig. 5 und 6 zeigt, kann aus einem Spannungsverlauf der Motorphasenspannungen Uu, Uv, Uw auf einfache Weise erkannt werden, ob ein Isolationsfehler auf der Seite der Motoranordnung 12, 18 vorliegt oder nicht.

Im Fall des dreiphasigen Stromnetzes fließt im Fehlerfall kontinuierlich ein Fehlerstrom $I_{R7}$, weil zu jeder Zeit mindestens eine Diode D7..12 des Brückengleichrichters 22 leitend ist.

Die Berechnung der Widerstandswerte und Fehlerströme des Isolationsfehlers erfolgt im Fall des dreiphasigen Stromnetzes mit den gleichen Formeln wie für das einphasige Stromnetz des ersten Ausführungsbeispiels.

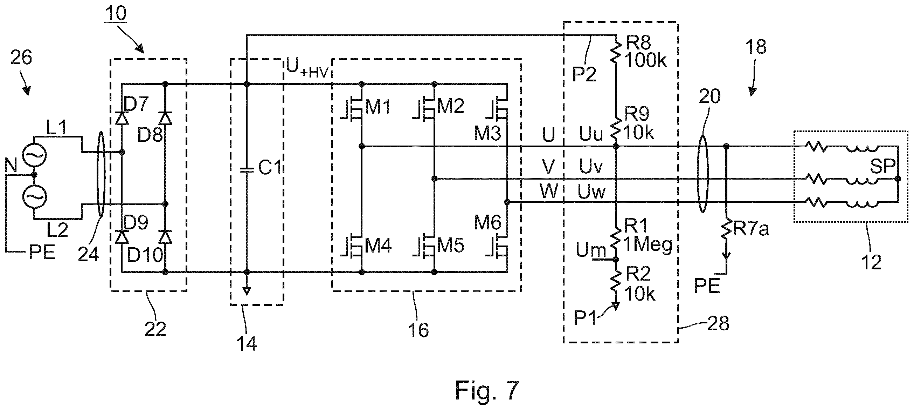

Bezug nehmend auf Fig. 7 bis 9 werden Aufbau und Funktionsweise einer Antriebsschaltung für einen elektronisch kommutierten Motor gemäß einem dritten Ausführungsbeispiel näher erläutert. Dabei sind gleiche bzw. entsprechende Komponenten und Parameter mit den gleichen Bezugszeichen wie in den vorherigen Ausführungsbeispielen versehen.

Im Ausführungsbeispiel von Fig. 7 ist das Versorgungsnetz 26 ein Einphasen-Dreileiternetz (USA), ist die Antriebsschaltung 10 mit den Phasenleitern L1, L2 des Dreileiternetzes verbunden, und hat das Versorgungsnetz 26 zudem einen mit Schutzerdung PE verbundenen Neutralleiter. Der Gleichrichter 22 weist in diesem Ausführungsbeispiel eine Gleichrichter-Brückenschaltung mit insgesamt vier Gleichrichterdioden D7 bis D10 auf. Im Übrigen entsprechen Aufbau und Funktionsweise der Antriebsschaltung 10 jenen des ersten Ausführungsbeispiels von Fig. 1. Im Gegensatz zum ersten Ausführungsbeispiel mit einphasigem Stromnetz müssen im Fall des Einphasen-Dreileiternetzes allerdings die Summen der ersten Widerstände R1, R2 und der weiteren Widerstände R8, R9 der Detektionsschaltung 28 ungleich groß sein, da andernfalls kein Fehlerstrom durch die Dioden des Gleichrichters 22 fließen würde. Auch in diesem Fall ist die eine Motorphase U aber hochohmig mit dem Minuspol des Gleichspannungszwischenkreises 14 verbunden.

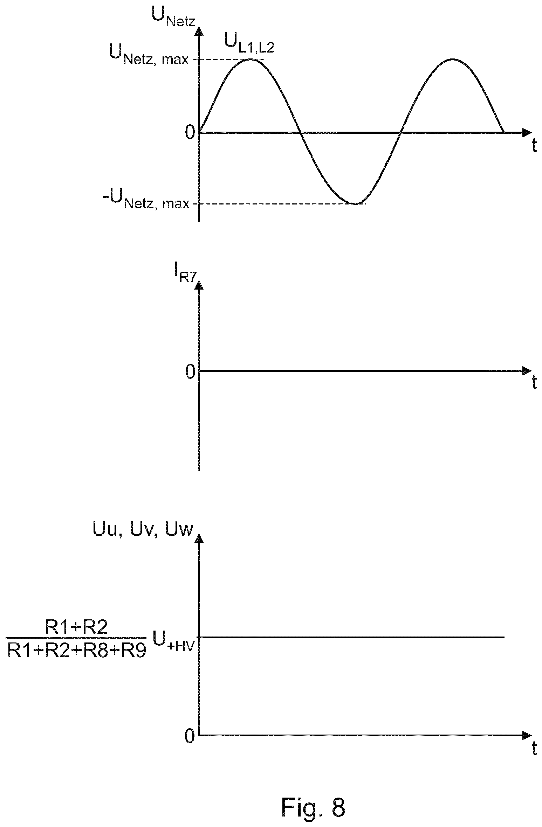

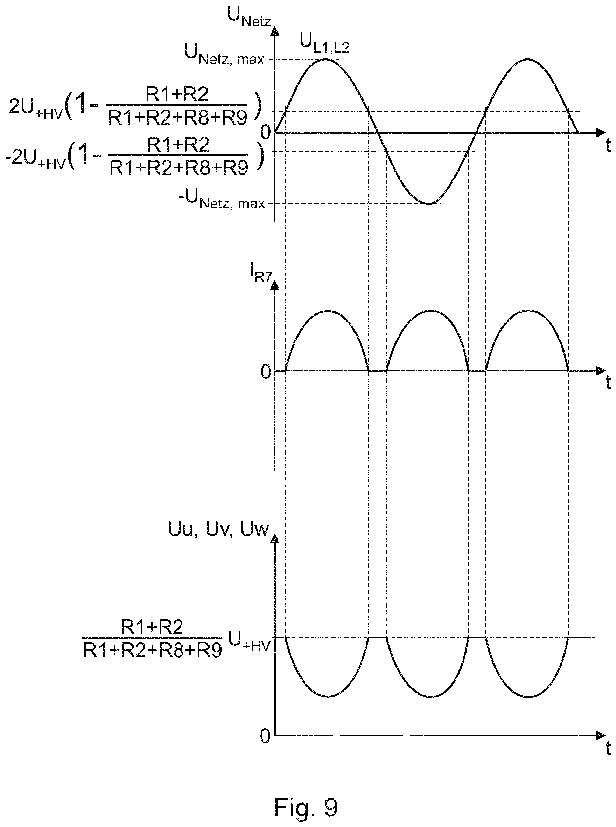

Die Diagramme von Fig. 8 zeigen die zeitlichen Verläufe der Netzspannung $U_{Netz}$, des Fehlerstroms $I_{R7}$ und der Motorphasenspannungen Uu, Uv, Uw im fehlerfreien Fall ohne einen Isolationsfehler, und die Diagramme von Fig. 9 zeigen die zeitlichen Verläufe der Netzspannung $U_{Netz}$, des Fehlerstroms $I_{R7}$ und der Motorphasenspannungen Uu, Uv, Uw im Fall eines Isolationsfehlers, jeweils während der Fehlerprüfung. Die Kurvenverläufe von Fig. 8 und 9 zeigen den Fall einer Fehlerprüfung für eine Antriebsschaltung 10 ohne PFC-Filter 30 bzw. bei ausgeschaltetem PFC-Filter 30; die Fehlerprüfung kann aber in analoger Weise auch bei eingeschaltetem PFC-Filter 30 durchgeführt werden.

Die Berechnung der Widerstandswerte und Fehlerströme des Isolationsfehlers erfolgt im Fall des Einphasen-Dreileiternetzes mit den gleichen Formeln wie für das einphasige Stromnetz des ersten Ausführungsbeispiels.

Im fehlerfreien Fall nimmt die Motorphasenspannung Uu den folgenden Wert an:

$$Uu = \frac{R1 + R2}{R1 + R2 + R8 + R9} * U_{+HV}$$

Im Fall des Einphasen-Dreileiternetzes fließt ein Fehlerstrom $I_{R7}$ erst dann, wenn die Netzspannung zwischen den beiden Außenleitern L1, L2 den folgenden Spannungswert übersteigt:

$$U_{Netz,L1,L2} = 2 * U_{+HV} * \left(1 - \frac{R1 + R2}{R1 + R2 + R8 + R9}\right)$$

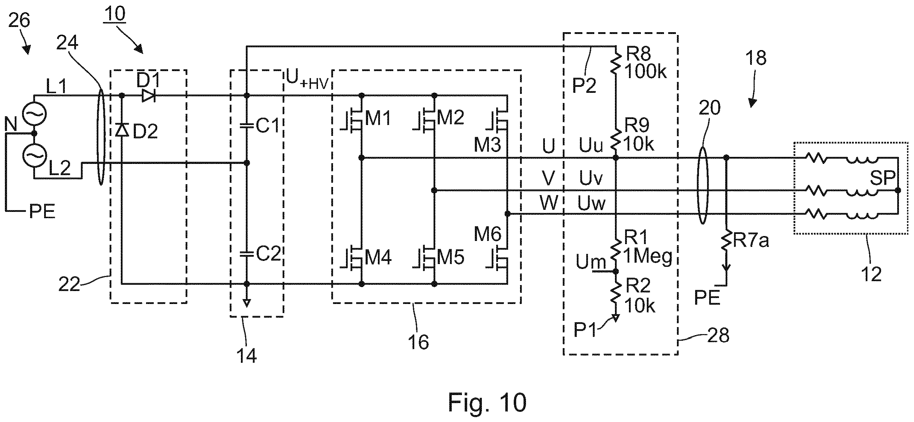

Bezug nehmend auf Fig. 10 bis 12 werden Aufbau und Funktionsweise einer Antriebsschaltung für einen elektronisch kommutierten Motor gemäß einem vierten Ausführungsbeispiel näher erläutert. Dabei sind gleiche bzw. entsprechende Komponenten und Parameter mit den gleichen Bezugszeichen wie in den vorherigen Ausführungsbeispielen versehen.

Im Ausführungsbeispiel von Fig. 10 ist das Versorgungsnetz 26 wie im dritten Ausführungsbeispiel ein Einphasen-Dreileiternetz (USA), ist die Antriebsschaltung 10 mit den Phasenleitern L1, L2 des Dreileiternetzes verbunden, und hat das Versorgungsnetz 26 zudem einen mit Schutzerdung PE verbundenen Neutralleiter. Im Gegensatz zum dritten Ausführungsbeispiel ist der Gleichrichter 22 in diesem Ausführungsbeispiel als Mittelpunktgleichrichter mit zwei Gleichrichterdioden D1 und D2 ausgebildet und hat der Gleichspannungszwischenkreis 14 zwei Zwischenkreiskondensatoren C1 und C2. Im Übrigen entsprechen Aufbau und Funktionsweise der Antriebsschaltung 10 jenen des ersten Ausführungsbeispiels von Fig. 1. Im Gegensatz zum ersten Ausführungsbeispiel mit einphasigem Stromnetz müssen im Fall des Einphasen-Dreileiternetzes allerdings die Summen der ersten Widerstände R1, R2 und der weiteren Widerstände R8, R9 der Detektionsschaltung 28 ungleich groß sein, da andernfalls kein Fehlerstrom durch die Dioden des Gleichrichters 22 fließen würde. Auch in diesem Fall ist die eine Motorphase U aber hochohmig mit dem Minuspol des Gleichspannungszwischenkreises 14 verbunden.

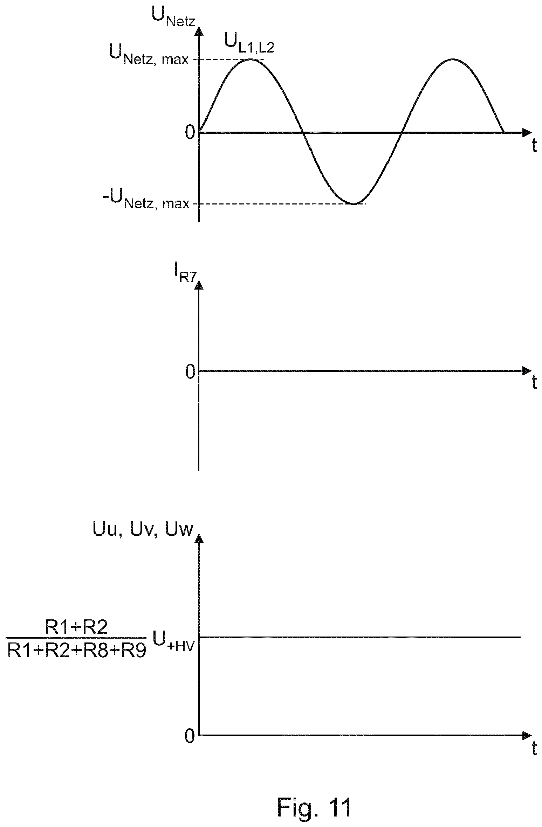

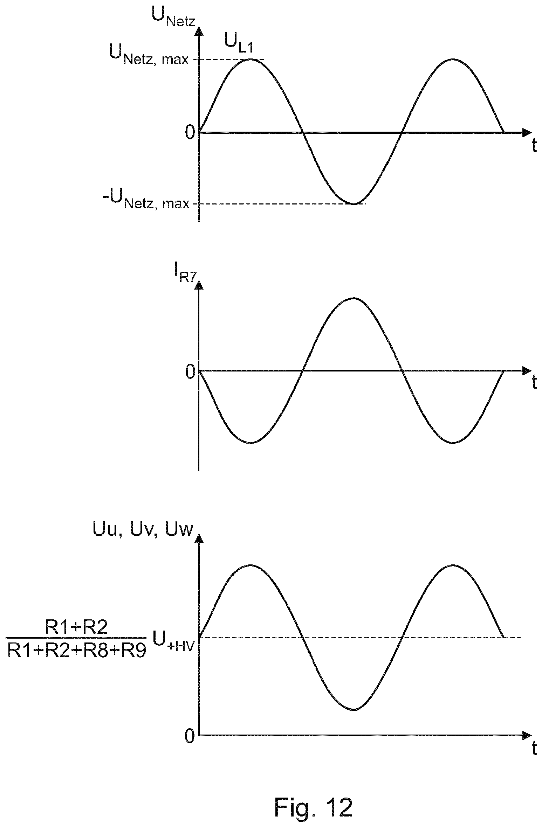

Die Diagramme von Fig. 11 zeigen die zeitlichen Verläufe der Netzspannung $U_{Netz}$, des Fehlerstroms $I_{R7}$ und der Motorphasenspannungen Uu, Uv, Uw im fehlerfreien Fall ohne einen Isolationsfehler, und die Diagramme von Fig. 12 zeigen die zeitlichen Verläufe der Netzspannung $U_{Netz}$, des Fehlerstroms $I_{R7}$ und der Motorphasenspannungen Uu, Uv, Uw im Fall eines Isolationsfehlers, jeweils während der Fehlerprüfung. Die Kurvenverläufe von Fig. 11 und 12 zeigen den Fall einer Fehlerprüfung für eine Antriebsschaltung 10 ohne PFC-Filter 30 bzw. bei ausgeschaltetem PFC-Filter 30; die Fehlerprüfung kann aber in analoger Weise auch bei eingeschaltetem PFC-Filter 30 durchgeführt werden.

Im fehlerfreien Fall nimmt die Motorphasenspannung Uu den folgenden Wert an:

$$Uu = \frac{R1 + R2}{R8 + R9 + R1 + R2} * U_{+HV}$$

Im Fall des Einphasen-Dreileiternetzes fließt ein Fehlerstrom $I_{R7}$ erst dann, wenn die Netzspannung zwischen den beiden Außenleitern L1, L2 den folgenden Spannungswert übersteigt:

$$U_{Netz,L1,L2} = 2 * U_{+HV} * \left(1 - \frac{R1 + R2}{R8 + R9 + R1 + R2}\right)$$

In der positiven Halbwelle der Netzspannung $U_{Netz}$ kann der Isolationsfehlerwiderstand R7 durch folgenden Ausdruck berechnet werden:

$$R7 = \frac{\left(U_{Netz} + {U_{+HV}}/{2} - \frac{R1 + R2}{R2} * Um\right) * (R1 + R2)}{\frac{R1 + R2}{R2} * Um - \frac{U_{+HV} - \frac{R1 + R2}{R2} * Um}{R8 + R9} * (R1 + R2)}$$

und in der negativen Halbwelle der Netzspannung $U_{Netz}$ kann der Isolationsfehlerwiderstand R7 durch folgenden Ausdruck berechnet werden:

$$R7 = \frac{(R8 + R9) * \left( U_{Netz} + \frac{R1 + R2}{R2} * Um - {U_{+HV}}/{2} \right)}{U_{+HV} - \frac{R1 + R2}{R2} * Um - (R8 + R9) * \frac{Um}{R2}}$$

In der positiven Halbwelle der Netzspannung $U_{Netz}$ kann der Fehlerstrom $I_{R7}$ während der Fehlerprüfung durch folgenden Ausdruck berechnet werden:

$$I_{R7} = \frac{Um}{R2} - \frac{U_{+HV} - \frac{R1 + R2}{R2} * Um}{R8 + R9}$$

und in der negativen Halbwelle der Netzspannung $U_{Netz}$ kann der Fehlerstrom $I_{R7}$ während der Fehlerprüfung durch folgenden Ausdruck berechnet werden:

$$I_{R7} = \frac{U_{+HV} - \frac{R1 + R2}{R2} * Um - (R8 + R9) * \frac{Um}{R2}}{R8 + R9}$$

Dementsprechend kann der maximal mögliche Fehlerstrom $I_{R7,max}$ im Betrieb mit eingeschaltetem Wechselrichter 16 während der positiven Halbwelle der Netzspannung $U_{Netz}$ durch folgenden Ausdruck ermittelt werden:

$$I_{R7,max} = \frac{U_{+HV}}{R7} = - \frac{U_{+HV} * \left( \frac{R1 + R2}{R2} * Um - \frac{U_{+HV} - \frac{R1 + R2}{R2} * Um}{R8 + R9} * (R1 + R2) \right)}{\left( U_{Netz} + {U_{+HV}}/{2} - \frac{R1 + R2}{R2} * Um \right) * (R1 + R2)}$$

und in der negativen Halbwelle der Netzspannung $U_{Netz}$ kann der maximal mögliche Fehlerstrom $I_{R7,max}$ durch folgenden Ausdruck berechnet werden:

$$I_{R7,max} = \frac{U_{+HV}}{R7} = - \frac{U_{+HV} * \left( U_{+HV} - \frac{R1 + R2}{R2} * Um - (R8 + R9) * \frac{Um}{R2} \right)}{(R8 + R9) * \left( U_{Netz} + \frac{R1 + R2}{R2} * Um - {U_{+HV}}/{2} \right)}$$

Bezug nehmend auf Fig. 13 wird nun eine alternative Ausführungsform der Detektionsschaltung 28' näher erläutert, die zum Beispiel anstelle der oben beschriebenen Detektionsschaltung 28 in Kombination mit den Antriebsschaltungen 10 von Fig. 1, 4, 7 und 10 eingesetzt werden kann, um neben dem Vorhandensein eines Isolationsfehlers R7a..d an einer Motorphase U, V, W auch das Vorhandensein einer Unterbrechung X einer Motorphase U, V, W erkennen zu können. Fig. 13 zeigt beispielhaft die Motorphasenfehler R7a, R7b, R7c und X, die mit Hilfe dieser Detektionsschaltung 28' erkannt werden können,

Die Detektionsschaltung 28' weist analog zur obigen Ausführungsvariante der Detektionsschaltung 28 einen Spannungsteiler aus zwei ersten Widerständen R1 und R2 auf, über die eine erste Motorphase (hier: W) hochohmig mit der Masse als erstem Bezugspotenzial P1 verbunden ist, um die entsprechende Motorphasenspannung Uw als Messspannung Um des Spannungsteilers R1, R2 zu erfassen und auszuwerten. Im Gegensatz zur obigen Ausführungsvariante der Detektionsschaltung 28 ist diese erste Motorphase W aber nicht auch mit dem Pluspol des Gleichspannungszwischenkreises 14 verbunden. Stattdessen sind die anderen Motorphasen U und V jeweils über zwei weitere Widerstände R3, R4 bzw. R5, R6 hochohmig mit dem Pluspol des Gleichspannungszwischenkreises 14 als zweiten Bezugspotenzial P2 verbunden. Über den Spannungsteiler R1, R2 wird somit eine runtergeteilte Motorphasenspannung Uw als Messspannung Um erfasst.

Im Fall des Anschlusses der Antriebsschaltung 10 an ein- oder mehrphasige Stromnetze 26 und von insgesamt drei Motorphasen U, V, W sind die Summen der Widerstandswerte R3+R4 und R5+R6 der weiteren Widerstände (z.B. etwa 2 Megaohm) sind dabei bevorzugt doppelt so groß wie die Summe der Widerstandswerte R1+R2 der ersten Widerstände (z.B. etwa 1 Megaohm), sodass die gemessene Motorphasenspannung Um im fehlerfreien Fall wie in den vorherigen Ausführungsbeispielen von Fig. 1 bis 12 wieder die halbe Zwischenkreisspannung annimmt.

Das Erkennen eines Isolationsfehlers R7a..c an einer Motorphase U, V, W und die Berechnungen des Isolationsfehlerwiderstands R7, des Fehlerstroms $I_{R7}$ während der Fehlerprüfung und des maximal möglichen Fehlerstroms $I_{R7,max}$ im Betrieb mit eingeschaltetem Wechselrichter 16 erfolgen analog zu den oben anhand von Fig. 1 bis 12 beschriebenen Fehlerprüfungen mit einer Detektionsschaltung 28. Bei Verwendung der Detektionsschaltung 28' von Fig. 12 verändert sich aber zudem die Motorphasenspannung Uw im Fall einer Unterbrechung X einer Motorphase, da dann nicht mehr alle Motorphasen U, V, W miteinander verbunden sind und der Wert der gemessenen Motorphasenspannung Um auch ohne Isolationsfehler R7a..c nicht die halbe Zwischenkreisspannung $U+_{HV}/2$ annimmt.

BEZUGSZIFFERNLISTE

| 10 | Antriebsschaltung |
|---|---|
| 12 | Motor |
| 14 | Gleichspannungszwischenkreis |
| 16 | Wechselrichter |
| 18 | Motorkabel |
| 20 | Motorphasenanschluss |
| 22 | Gleichrichter |
| 24 | Wechselstromanschluss |
| 26 | Versorgungsnetz |
| 28, 28' | Detektionsschaltung |
| 30 | Leistungsfaktorkorrekturfilter (PFC-Filter) |

| C1, C2 | Zwischenkreiskondensator von 14 |
|---|---|
| D1, D2 | Gleichrichterdioden von 22 |
| D5 | Gleichrichterdiode von 30 |
| D7 - D12 | Gleichrichterdioden von 22 |
| L1, L2, L3 | Phasenleiter von 26 |
| L8 | Induktivität von 30 |
| M1 - M6 | Leistungsschalter von 16 |
| M8 | Schalter von 30 |
| N | Neutralleiter von 26 |
| PE | Schutzerdung |
| P1 | erstes Bezugspotenzial |
| P2 | zweites Bezugspotenzial |
| R1, R2 | erste Widerstände von 28, 28' |
| R3, R4 | weitere Widerstände von 28' |
| R5, R6 | weitere Widerstände von 28' |
| R7 | Isolationsfehlerwiderstand |
| R7a..d | Isolationsfehler-Widerstände |
| R8, R9 | weitere Widerstände von 28 |
| SP | Sternpunkt von 12 |
| U, V, W | Motorphasen von 12, 16, 18 |
| X | Unterbrechung einer Motorphase |
| $\Delta I$ | Kondensatorstrom |
| $I_{R7}$ | Fehlerstrom |
| $U_{+HV}$ | Zwischenkreisspannung |
| $U_{Lx}$ | Netzphasenspannung |
| Um | von 28, 28' erfasste Spannung |
| $U_{Netz}$ | Netzspannung |
| Uu, Uv, Uw | Motorphasenspannungen |

**Patentansprüche**

1. Verfahren zum Erkennen eines Motorphasenfehlers (R7a..d; X) einer Motoranordnung (12, 18), deren Motorphasen (U, V, W) an einer Antriebsschaltung (10) mit einem Gleichspannungszwischenkreis (14) und einem Wechselrichter (16) angeschlossen sind, wobei

   mindestens eine Motorphase (U, V, W) über erste Widerstände (R1, R2) mit einem ersten Bezugspotenzial (P1) und über weitere Widerstände (R8, R9) mit einem zweiten Bezugspotenzial (P2) verbunden wird, oder eine erste Motorphase (W) der Motorphasen (U, V, W) über erste Widerstände (R1, R2) mit einem ersten Bezugspotenzial (P1) verbunden wird und die anderen Motorphasen (U, V) der Motorphasen (U, V, W) jeweils über weitere Widerstände (R3, R4; R5, R6) mit einem zweiten Bezugspotenzial (P2) verbunden werden;

   eine runtergeteilte Motorphasenspannung (Uu, Uv, Uw) der einen Motorphase (U, V, W) oder eine runtergeteilte Motorphasenspannung (Uw) der ersten Motorphase (W) gegen das erste Bezugspotenzial (P1) erfasst wird, während der Wechselrichter (16) ausgeschaltet ist; und

   anhand eines Spannungsverlaufs der erfassten runtergeteilten Motorphasenspannung (Uu, Uv, Uw) festgestellt wird, ob ein Motorphasenfehler (R7a..d; X) an einer der Motorphasen (U, V, W) der Motoranordnung (12, 18) vorhanden ist,

   die runtergeteilte Motorphasenspannung (Uu, Uv, Uw) der einen Motorphase (U, V, W) oder die runtergeteilte Motorphasenspannung (Uw) der ersten Motorphase (W) mittels eines Spannungsteilers (R1, R2) erfasst wird;
   **dadurch gekennzeichnet, dass**

   anhand der erfassten Motorphasenspannung (Uu, Uv, Uw) ein Fehlerstromwert ($I_{R7}$) eines Isolationsfehlers (R7a..d) während der Fehlerprüfung und/oder ein Widerstandswert (R7) des Isolationsfehlers (R7a..d) und/oder ein maximal möglicher Fehlerstromwert ($I_{R7,max}$) des Isolationsfehlers (R7a..d) im Betrieb mit eingeschaltetem Wechselrichter (16) quantitativ berechnet werden; und

   der Fehlerstromwert ($I_{R7}$) des Isolationsfehlers (R7a..d) während der Fehlerprüfung und/oder der Widerstandswert (R7) des Isolationsfehlers (R7a..d) und/oder der maximal mögliche Fehlerstromwert ($I_{R7,max}$) des Isolationsfehlers (R7a..d) allein anhand der Widerstandswerte der ersten Widerstände (R1, R2) und der weiteren Widerstände (R3, R4; R5, R6; R8, R9), einer mittels des Spannungsteilers (R1, R2) erfassten Messspannung (Um) der runtergeteilten Motorphasenspannung (Uu, Uv, Uw), einer Netzspannung ($U_{Netz}$) eines Versorgungsnetzes (26) und einer Zwischenkreisspannung (U+HV) über dem Gleichspannungszwischenkreis (14) berechnet werden.

2. Verfahren zum Betreiben einer Antriebsschaltung (10) mit einem Gleichspannungszwischenkreis (14) und einem Wechselrichter (16) zum Antreiben eines elektronisch kommutierten Motors (12), wobei die Motorphasen (U, V, W) einer den Motor (12) enthaltenden Motoranordnung (12, 18) an dem Wechselrichter (16) der Antriebsschaltung (10) angeschlossen sind, bei welchem ein Vorhandensein eines Motorphasenfehlers (R7a..d; X) der Motoranordnung (12, 18) gemäß dem Verfahren nach Anspruch 1 geprüft wird und ein Einschalten des Wechselrichters (16) und/oder eines Leistungsfaktorkorrekturfilters (30) der Antriebsschaltung (10) nach dem Erfassen der runtergeteilten Motorphasenspannung (Uu, Uv, Uw) verhindert wird, falls ein Motorphasenfehler (R7a..d; X) festgestellt worden ist.

3. Verfahren zum Betreiben einer Antriebsschaltung (10) mit einem Gleichspannungszwischenkreis (14), einem Leistungsfaktorkorrekturfilter (30) und einem Wechselrichter (16) zum Antreiben eines elektronisch kommutierten Motors (12), wobei die Motorphasen (U, V, W) einer den Motor (12) enthaltenden Motoranordnung (12, 18) an dem Wechselrichter (16) der Antriebsschaltung (10) angeschlossen sind, bei welchem ein Vorhandensein eines Motorphasenfehlers (R7a..d; X) der Motoranordnung (12, 18) gemäß dem Verfahren nach Anspruch 1 geprüft wird und der Leistungsfaktorkorrekturfilter (30) beim Antreiben des Motors (12) nach dem Erfassen der runtergeteilten Motorphasenspannung (Uu, Uv, Uw) abgeschaltet wird, falls der maximal mögliche Fehlerstromwert ($I_{R7,max}$) des Isolationsfehlers (R7a..d) an einer Motorphase (U, V, W) unterhalb eines vorgegebenen Grenzwerts festgestellt worden ist.

4. Antriebsschaltung (10) zum Antreiben eines elektronisch kommutierten Motors (12), aufweisend:

   einen Gleichspannungszwischenkreis (14);
   einen mit dem Gleichspannungszwischenkreis (14) verbundenen Wechselrichter (16), an den die Motorphasen (U, V, W) einer den Motor (12) enthaltenden Motoranordnung (12, 18) anschließbar sind;
   eine Detektionsschaltung (28, 28') zum Erfassen einer Motorphasenspannung (Uu, Uv, Uw) an mindestens einer der Motorphasen (U, V, W) gegen ein Bezugspotenzial (P1), die erste Widerstände (R1, R2), über die mindestens eine Motorphase (U, V, W) mit einem ersten Bezugspotenzial (P1) verbunden ist, und weitere Widerstände (R8, R9), über die die mindestens eine Motorphase (U, V, W) mit einem zweiten Bezugspotenzial (P2) verbunden ist, oder erste Widerstände (R1, R2), über die eine erste Motorphase (W) der Motorphasen (U, V, W) mit einem ersten Bezugspotenzial (P1) verbunden ist, und weitere Widerstände (R3, R4; R5, R6), über die jeweils eine andere Motorphase (U, V) der Motorphasen (U, V, W) mit einem zweiten Bezugspotenzial (P2) verbunden ist, aufweist; und

eine Steuereinrichtung, die ausgestaltet ist, um die Detektionsschaltung (28, 28') zum Erfassen der Motorphasenspannung (Uu, Uv, Uw) zu betreiben, während der Wechselrichter (16) ausgeschaltet ist, und um anhand eines Spannungsverlaufs der erfassten Motorphasenspannung (Uu, Uv, Uw) festzustellen, ob ein Motorphasenfehler (R7a..d; X) an einer der Motorphasen (U, V, W) der Motoranordnung (12, 18) vorhanden ist,

die Detektionsschaltung (28, 28') einen Spannungsteiler (R1, R2) zum Erfassen einer runtergeteilten Motorphasenspannung (Uu, Uv, Uw) der einen Motorphase (U, V, W) oder einer runtergeteilten Motorphasenspannung (Uw) der ersten Motorphase (W) aufweist; und

**dadurch gekennzeichnet, dass**

die Steuereinrichtung ferner ausgestaltet ist, um anhand der erfassten Motorphasenspannung (Uu, Uv, Uw) einen Fehlerstromwert ($I_{R7}$) eines Isolationsfehlers (R7a..d) während der Fehlerprüfung und/oder einen Widerstandswert (R7) des Isolationsfehlers (R7a..d) und/oder einen maximal möglichen Fehlerstromwert ($I_{R7,max}$) des Isolationsfehlers (R7a..d) im Betrieb mit eingeschaltetem Wechselrichter (16) allein anhand der Widerstandswerte der ersten Widerstände (R1, R2) und der weiteren Widerstände (R3, R4; R5, R6; R8, R9), einer mittels des Spannungsteilers (R1, R2) erfassten Messspannung (Um) der runtergeteilten Motorphasenspannung (Uu, Uv, Uw), einer Netzspannung ($U_{Netz}$) eines Versorgungsnetzes (26) und einer Zwischenkreisspannung (U+HV) über dem Gleichspannungszwischenkreis (14) quantitativ zu berechnen.

5.  Antriebsschaltung nach Anspruch 4, bei welcher
    die Steuereinrichtung ausgestaltet ist, um ein Einschalten des Wechselrichters (16) und/oder eines Leistungsfaktorkorrekturfilters (30) nach dem Erfassen der Motorphasenspannung (Uu, Uv, Uw) zu verhindern, falls ein Motorphasenfehler (R7a..d; X) festgestellt worden ist.

6.  Antriebsschaltung nach Anspruch 4, welche ferner einen Leistungsfaktorkorrekturfilter (30) aufweist, und bei welcher
    die Steuereinrichtung ausgestaltet ist, um den Leistungsfaktorkorrekturfilter (30) beim Antreiben des Motors (12) nach dem Erfassen der Motorphasenspannung (Uu, Uv, Uw) abzuschalten, falls der maximal mögliche Fehlerstromwert ($I_{R7,max}$) des Isolationsfehlers (R7a..d) an einer Motorphase (U, V, W) unterhalb eines vorgegebenen Grenzwerts festgestellt worden ist.

## Claims

1.  Method for detecting a motor phase fault (R7a..d; X) of a motor arrangement (12, 18), the motor phases (U, V, W) of which are connected to a drive circuit (10) having a DC voltage intermediate circuit (14) and an inverter (16), wherein at least one motor phase (U, V, W) is connected to a first reference potential (P1) via first resistors (R1, R2) and is connected to a second reference potential (P2) via further resistors (R8, R9), or a first motor phase (W) of the motor phases (U, V, W) is connected to a first reference potential (P1) via first resistors (R1, R2) and the other motor phases (U, V) of the motor phases (U, V, W) are each connected to a second reference potential (P2) via further resistors (R3, R4; R5, R6);

    a divided motor phase voltage (Uu, Uv, Uw) of one motor phase (U, V, W) or a divided motor phase voltage (Uw) of the first motor phase (W) with respect to the first reference potential (P1) is captured while the inverter (16) is switched off; and

    a voltage profile of the captured divided motor phase voltage (Uu, Uv, Uw) is used to determine whether there is a motor phase fault (R7a..d; X) on one of the motor phases (U, V, W) of the motor arrangement (12, 18), the divided motor phase voltage (Uu, Uv, Uw) of one motor phase (U, V, W) or the divided motor phase voltage (Uw) of the first motor phase (W) is captured by means of a voltage divider (R1, R2),

    **characterized in that**

    a fault current value ($I_{R7}$) of an insulation fault (R7a..d) during the fault check and/or a resistance value (R7) of the insulation fault (R7a..d) and/or a maximum possible fault current value ($I_{R7,max}$) of the insulation fault (R7a..d) are/is quantitatively calculated during operation with the inverter (16) switched on on the basis of the captured motor phase voltage (Uu, Uv, Uw); and the fault current value ($I_{R7}$) of the insulation fault (R7a..d) during the fault check and/or the resistance value (R7) of the insulation fault (R7a..d) and/or the maximum possible fault current value ($I_{R7,max}$) of the insulation fault (R7a..d) are/is calculated solely on the basis of the resistance values of the first resistors (R1, R2) and the further resistors (R3, R4; R5, R6; R8, R9), a measurement voltage (Um) of the divided motor phase voltage (Uu, Uv, Uw), as captured by means of the voltage divider (R1, R2), a network voltage ($U_{Netz}$) of a supply network (26) and an intermediate circuit voltage (U+HV) across the DC voltage intermediate circuit (14).

**2.** Method for operating a drive circuit (10) having a DC voltage intermediate circuit (14) and an inverter (16) for driving an electronically commutated motor (12), wherein the motor phases (U, V, W) of a motor arrangement (12, 18) containing the motor (12) are connected to the inverter (16) of the drive circuit (10), in which method a presence of a motor phase fault (R7a..d; X) of the motor arrangement (12, 18) is checked in accordance with the method according to Claim 1, and switching-on of the inverter (16) and/or of a power factor correction filter (30) of the drive circuit (10) after capturing the divided motor phase voltage (Uu, Uv, Uw) is prevented if a motor phase fault (R7a..d; X) has been determined.

**3.** Method for operating a drive circuit (10) having a DC voltage intermediate circuit (14), a power factor correction filter (30) and an inverter (16) for driving an electronically commutated motor (12), wherein the motor phases (U, V, W) of a motor arrangement (12, 18) containing the motor (12) are connected to the inverter (16) of the drive circuit (10), in which method a presence of a motor phase fault (R7a..d; X) of the motor arrangement (12, 18) is checked in accordance with the method according to Claim 1, and the power factor correction filter (30) is switched off when driving the motor (12) after capturing the divided motor phase voltage (Uu, Uv, Uw) if the maximum possible fault current value ($I_{R7,max}$) for the insulation fault (R7a..d) on a motor phase (U, V, W) below a predefined limit value has been determined.

**4.** Drive circuit (10) for driving an electronically commutated motor (12), having:

a DC voltage intermediate circuit (14);
an inverter (16), which is connected to the DC voltage intermediate circuit (14) and to which the motor phases (U, V, W) of a motor arrangement (12, 18) containing the motor (12) can be connected,
a detection circuit (28, 28') for capturing a motor phase voltage (Uu, Uv, Uw) at at least one of the motor phases (U, V, W) with respect to a reference potential (P1), which detection circuit has at least first resistors (R1, R2), via which the at least one motor phase (U, V, W) is connected to a first reference potential (P1), and further resistors (R8, R9), via which the at least one motor phase (U, V, W) is connected to a second reference potential (P2), or first resistors (R1, R2), via which a first motor phase (W) of the motor phases (U, V, W) is connected to a first reference potential (P1), and further resistors (R3, R4; R5, R6), via which another motor phase (U, V) of the motor phases (U, V, W) is respectively connected to a second reference potential (P2); and
a control device which is configured to operate the detection circuit (28, 28') for capturing the motor phase voltage (Uu, Uv, Uw) while the inverter (16) is switched off and to determine, on the basis of a voltage profile of the captured motor phase voltage (Uu, Uv, Uw), whether there is a motor phase fault (R7a..d; X) on one of the motor phases (U, V, W) of the motor arrangement (12, 18), the detection circuit (28, 28') has a voltage divider (R1, R2) for capturing a divided motor phase voltage (Uu, Uv, Uw) of one motor phase (U, V, W) or a divided motor phase voltage (Uw) of the first motor phase (W); and
**characterized in that**
the control device is further configured to quantitatively calculate a fault current value ($I_{R7}$) of an insulation fault (R7a..d) during the fault check and/or a resistance value (R7) of the insulation fault (R7a..d) and/or a maximum possible fault current value ($I_{R7,max}$) of the insulation fault (R7a..d) during operation with the inverter (16) switched on solely on the basis of the resistance values of the first resistors (R1, R2) and the further resistors (R3, R4; R5, R6; R8, R9), a measurement voltage (Um) of the divided motor phase voltage (Uu, Uv, Uw), as captured by means of the voltage divider (R1, R2), a network voltage ($U_{Netz}$) of a supply network (26) and an intermediate circuit voltage (U+HV) across the DC voltage intermediate circuit (14).

**5.** Drive circuit according to Claim 4, in which the control device is designed to prevent switching-on of the inverter (16) and/or of a power factor correction filter (30) after capturing the motor phase voltage (Uu, Uv, Uw) if a motor phase fault (R7a..d; X) has been determined.

**6.** Drive circuit according to Claim 4, which further has a power factor correction filter (30) and in which the control device is designed to switch off the power factor correction filter (30) when driving the motor (12) after capturing the motor phase voltage (Uu, Uv, Uw) if the maximum possible fault current value ($I_{R7,max}$) for the insulation fault (R7a..d) on a motor phase (U, V, W) below a predefined limit value has been determined.

**Revendications**

**1.** Procédé permettant de détecter un défaut de phase moteur (R7a ... d ; X) d'un ensemble moteur (12, 18) dont les phases moteur (U, V, W) sont connectées à un circuit d'entraînement (10) avec un circuit intermédiaire de tension continue (14) et un onduleur (16), dans lequel

au moins une phase moteur (U, V, W) est reliée par des premières résistances (R1, R2) à un premier potentiel de référence (P1) et par d'autres résistances (R8, R9) à un deuxième potentiel de référence (P2), ou une première phase moteur (W) des phases moteur (U, V, W) est reliée par des premières résistances (R1, R2) à un premier potentiel de référence (P1) et les autres phases moteur (U, V) des phases moteur (U, V, W) sont respectivement reliées par d'autres résistances (R3, R4 ; R5, R6) à un deuxième potentiel de référence (P2) ;

une tension de phase moteur divisée (Uu, Uv, Uw) de ladite une phase moteur (U, V, W) ou une tension de phase moteur divisée (Uw) de la première phase moteur (W) est détectée par rapport au premier potentiel de référence (P1) pendant que l'onduleur (16) est hors tension ; et

à l'aide d'une courbe de tension de la tension de phase moteur divisée (Uu, Uv, Uw) détectée, il est constaté si un défaut de phase moteur (R7a ... d ; X) existe sur l'une des phases moteur (U, V, W) de l'ensemble moteur (12, 18), la tension de phase moteur divisée (Uu, Uv, Uw) de ladite une phase moteur (U, V, W) ou la tension de phase moteur divisée (Uw) de la première phase moteur (W) est détecté au moyen d'un diviseur de tension (R1, R2), **caractérisé en ce qu'**à l'aide de la tension de phase moteur détectée (Uu, Uv, Uw), on calcule quantitativement une valeur de courant de défaut ($I_{R7}$) d'un défaut d'isolation (R7a ... d) pendant le contrôle de défauts et/ou une valeur de résistance (R7) du défaut d'isolation (R7a ... d) et/ou une valeur de courant de défaut maximale ($I_{R7,max}$) possible du défaut d'isolation (R7a ... d) en cours de fonctionnement lorsque l'onduleur (16) est sous tension ; et la valeur de courant de défaut ($I_{R7}$) du défaut d'isolation (R7a ... d) pendant le contrôle de défauts et/ou la valeur de résistance (R7) du défaut d'isolation (R7a ... d) et/ou la valeur de courant de défaut maximale ($I_{R7,max}$) possible du défaut d'isolation (R7a ... d) sont calculées uniquement à l'aide des valeurs de résistance des premières résistances (R1, R2) et des autres résistances (R3, R4 ; R5, R6 ; R8, R9), d'une tension de mesure (Um), détectée au moyen du diviseur de tension (R1, R2), de la tension de phase moteur divisée (Uu, Uv, Uw), d'une tension de réseau ($U_{Netz}$) d'un réseau d'alimentation (26) et d'une tension de circuit intermédiaire (U+HV) aux bornes du circuit intermédiaire de tension continue (14).

2. Procédé permettant de faire fonctionner un circuit d'entraînement (10) avec un circuit intermédiaire de tension continue (14) et un onduleur (16) afin d'entraîner un moteur (12) à commutation électronique, dans lequel les phases moteur (U, V, W) d'un ensemble moteur (12, 18) comprenant le moteur (12) sont connectées à l'onduleur (16) du circuit d'entraînement (10), pour lequel la présence d'un défaut de phase moteur (R7a ... d ; X) de l'ensemble moteur (12, 18) est contrôlée selon le procédé selon la revendication 1, et une mise sous tension de l'onduleur (16) et/ou d'un filtre de correction de facteur de puissance (30) du circuit d'entraînement (10) est empêchée après la détection de la tension de phase moteur divisée (Uu, Uv, Uw) si un défaut de phase moteur (R7a ... d ; X) a été constaté.

3. Procédé permettant de faire fonctionner un circuit d'entraînement (10) avec un circuit intermédiaire de tension continue (14), un filtre de correction de facteur de puissance (30) et un onduleur (16) afin d'entraîner un moteur (12) à commutation électronique, dans lequel les phases moteur (U, V, W) d'un ensemble moteur (12, 18) comprenant le moteur (12) sont connectées à l'onduleur (16) du circuit d'entraînement (10), pour lequel une présence d'un défaut de phase moteur (R7a ... d ; X) de l'ensemble moteur (12, 18) est contrôlée selon le procédé selon la revendication 1, et le filtre de correction de facteur de puissance (30) lors de l'entraînement du moteur (12) est mis hors tension après la détection de la tension de phase moteur divisée (Uu, Uv, Uw) si la valeur de courant de défaut maximale ($I_{R7,max}$) possible du défaut d'isolation (R7a ... d) sur une phase moteur (U, V, W) a été constatée au-dessous d'une valeur limite prédéfinie.

4. Circuit d'entraînement (10) permettant d'entraîner un moteur (12) à commutation électronique, présentant :

   un circuit intermédiaire de tension continue (14) ;
   un onduleur (16) relié au circuit intermédiaire de tension continue (14) et auquel les phases moteur (U, V, W) d'un ensemble moteur (12, 18) comprenant le moteur (12) peuvent être connectées ;
   un circuit de détection (28, 28') pour détecter une tension de phase moteur (Uu, Uv, Uw) sur au moins l'une des phases moteur (U, V, W) par rapport à un potentiel de référence (P1), qui présente des premières résistances (R1, R2) par lesquelles au moins une phase moteur (U, V, W) est reliée à un premier potentiel de référence (P1), et d'autres résistances (R8, R9) par lesquelles ladite au moins une phase moteur (U, V, W) est reliée à un deuxième potentiel de référence (P2), ou des premières résistances (R1, R2) par lesquelles une première phase moteur (W) des phases moteur (U, V, W) est reliée à un premier potentiel de référence (P1), et d'autres résistances (R3, R4 ; R5, R6) par lesquelles respectivement une autre phase moteur (U, V) des phases moteur (U, V, W) est reliée à un deuxième potentiel de référence (P2) ; et
   un dispositif de commande qui est configuré pour faire fonctionner le circuit de détection (28, 28') afin de détecter la tension de phase moteur (Uu, Uv, Uw) pendant que l'onduleur (16) est hors tension, et afin de constater à l'aide d'une courbe de tension de la tension de phase moteur (Uu, Uv, Uw) détectée si un défaut de phase moteur (R7a ... d ; X) existe sur l'une des phases moteur (U, V, W) de l'ensemble moteur (12, 18),

le circuit de détection (28, 28') présente un diviseur de tension (R1, R2) pour détecter une tension de phase moteur divisée (Uu, Uv, Uw) de ladite une phase moteur (U, V, W) ou une tension de phase moteur divisée (Uw) de la première phase moteur (W) ; et

**caractérisé en ce que** le dispositif de commande est en outre configuré pour calculer quantitativement à l'aide de la tension de phase moteur (Uu, Uv, Uw) détectée une valeur de courant de défaut ($I_{R7}$) d'un défaut d'isolation (R7a ... d) pendant le contrôle de défauts et/ou une valeur de résistance (R7) du défaut d'isolation (R7a ... d) et/ou une valeur de courant de défaut maximale ($I_{R7,max}$) possible du défaut d'isolation (R7a ... d) en cours de fonctionnement lorsque l'onduleur (16) est sous tension, uniquement à l'aide des valeurs de résistance des premières résistances (R1, R2) et d'autres résistances (R3, R4 ; R5, R6 ; R8, R9), d'une tension de mesure (Um), détectée au moyen du diviseur de tension (R1, R2), de la tension de phase moteur divisée (Uu, Uv, Uw), d'une tension de réseau ($U_{Netz}$) d'un réseau d'alimentation (26) et d'une tension de circuit intermédiaire (U+HV) aux bornes du circuit intermédiaire de tension continue (14).

5. Circuit d'entraînement selon la revendication 4, dans lequel le dispositif de commande est configuré pour empêcher une mise sous tension de l'onduleur (16) et/ou d'un filtre de correction de facteur de puissance (30) après la détection de la tension de phase moteur (Uu, Uv, Uw) si un défaut de phase moteur (R7a ... d ; X) a été constaté.

6. Circuit d'entraînement selon la revendication 4, qui présente en outre un filtre de correction de facteur de puissance (30), et dans lequel le dispositif de commande est configuré pour mettre hors tension le filtre de correction de facteur de puissance (30) lors de l'entraînement du moteur (12) après la détection de la tension de phase moteur (Uu, Uv, Uw) si la valeur de courant de défaut maximale ($I_{R7,max}$) possible du défaut d'isolation (R7a ... d) sur une phase moteur (U, V, W) a été constatée au-dessous d'une valeur limite prédéfinie.

Fig. 1

$U_{Netz}$

$U_{Netz, max}$

0

$-U_{Netz, max}$

t

$I_{R7}$

0

t

$U_u, U_v, U_w$

$\dfrac{U_{+HV}}{2}$

0

t

Fig. 2

Fig. 3

Fig. 4

Fig. 5

Fig. 6

Fig. 7

Fig. 8

Fig. 9

Fig. 10

$U_{Netz}$

$U_{Netz, max}$ — — — — $U_{L1,L2}$

0

$-U_{Netz, max}$ — — — — —

t

$I_{R7}$

0

t

$U_u, U_v, U_w$

$$\frac{R1+R2}{R1+R2+R8+R9} U_{+HV}$$

0

t

Fig. 11

$$\frac{R1+R2}{R1+R2+R8+R9} U_{+HV}$$

Fig. 12

Fig. 13

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6043664 A
- DE 102015105260 A1